# EUROPÄISCHE PATENTANMELDUNG

(11) **EP 2 980 464 A1**
(43) Veröffentlichungstag der Anmeldung: **03.02.2016**
(21) Anmeldenummer: 14178982.6
(22) Anmeldetag: 29.07.2014
(51) Int. Cl.: F16L 5/02, G01F 1/00, G01F 15/00, H01R 13/52

(54) **Dichtkörper, Verfahren zur Herstellung des Dichtkörpers und ein Gehäuse**

(71) Anmelder: GWF MessSysteme AG, 6002 Luzern (CH)
(72) Erfinder: Wyss, Jörg, 6004 Luzern (CH); Kayser, Ralph, 6004 Luzern (CH); Hubacher, Samuel, 4934 Madiswil (CH); Furrer, Walter, 6102 Malters (CH); Frey, Thomas, 6403 Küssnacht am Rigi (CH)
(74) Vertreter: Escher, Jean-Philippe

(57) **Zusammenfassung**

Die Erfindung betrifft einen Dichtkörper (101) mit einer Leiterführung (6a, 6b, 6c) zur Durchführung eines Leiters (7a, 7b, 7c). Der Dichtkörper (101) ist vorgefertigt. Das Leiterende (13) der Leiter (7a, 7b, 7c) ist zumindest teilweise abisoliert. Eine Übergangsstelle (11) von isoliertem Leiter (7a, 7b, 7c) zum teilweise abisolierten Leiterende (13) in der Leiterführung (6a, 6b, 6c) innerhalb des Dichtkörpers (101) angeordnet.

## Beschreibung

Die Erfindung betrifft einen Dichtkörper, ein Verfahren zur Herstellung eines Dichtkörpers sowie ein Gehäuse gemäss den Oberbegriffen der unabhängigen Ansprüche.

Solche Dichtkörper kommen typischerweise bei Gehäusen mit einem Innenraum für Messinstrumente zum Einsatz. Messinstrumente sind beispielsweise Wasserzähler, Gaszähler oder Stromzähler. Da solche Messinstrumente häufig im Aussenbereich und zunehmend auch unterirdisch zum Einsatz kommen, müssen die Gehäuse so konstruiert sein, dass die Messeinrichtungen der Messinstrumente vor Feuchtigkeit und Staub geschützt sind. Die Bereiche eines Gehäuses, die zur Durchführung von elektrischen Leitern von der Umgebung in das Innere des Gehäuses vorgesehen sind, sind dabei besonders zu beachten.

Es ist bekannt, solche Durchführungen für einen besseren Schutz gegen eindringendes Wasser in die Abdichtung eines Gehäuses zu integrieren. Mit der GB 2 317 273 A wurde z.B. eine Durchführung bekannt, bei welcher zur zusätzlichen Abdichtung die Leiter in einen Epoxidkleber eingegossen wurden. Vor dem Eingiessen werden die Leiter in einem Gummistecker so angebracht, dass beim Vergiessen des Epoxidklebers in einen dafür vorgesehenen Teil des Gehäuses und nach Aushärten desselbigen ein abgedichtetes, fest verschlossenes Gehäuse entsteht. Diese Art der Durchführung hat jedoch den Nachteil, dass sie aufwendig in der Herstellung ist und mehrere einzelne Komponenten für die Abdichtung notwendig sind. Beim Ausgiessen müssen zudem bestimmte Aushärtezeiten und Temperaturen beachtet werden.

Es ist daher eine Aufgabe der Erfindung, die Nachteile des Standes der Technik zu überwinden. Insbesondere ist es eine Aufgabe der Erfindung, einen in der Herstellung kostengünstigen Dichtkörper mit einer Leiterführung zur Durchführung eines Leiters sowie ein Verfahren zur Herstellung eines solchen Dichtkörpers zu schaffen. Eine weitere Aufgabe der Erfindung ist es, ein kostengünstiges und zuverlässig wasserdichtes Gehäuse für Messinstrumente zu schaffen.

Diese Aufgaben werden durch die in den unabhängigen Patentansprüchen definierten Vorrichtungen und Verfahren gelöst. Weitere Ausführungsformen ergeben sich aus den abhängigen Patentansprüchen.

Die Erfindung betrifft einen Dichtkörper mit einer Leiterführung zur Durchführung eines oder mehrerer Leiter. Der Dichtkörper mit Leiter kann vorgefertigt sein und so einfach in einer abzudichtenden Einrichtung (z.B. zum Abdichten eines Gehäuses für ein Messinstrument, wie etwa einem Wasserzähler) verbaut werden. Der Dichtkörper und der oder die mit dem Dichtkörper verbundenen Leiter bilden eine Baueinheit, die sich einfach herstellen, lagern und zum Abdichten eines Gehäuses eines Messinstruments bei Bedarf verwenden lässt. Die Verwendung der beschriebenen Baueinheit aus Dichtkörper und Leiter hat auch Vorteile hinsichtlich der Produktivität. Messinstrumente lassen sich einfach und mit wenigen Arbeitssehritten zusammenbauen. Der Leiter kann eine oder mehrere Litzen oder Drähte (z.B. aus Kupfer) und die Litzen oder Drähte umhüllende Isolierungen umfassen. Derartige Leiter können zum Beispiel Kabel sein. Der Leiter weist eine elektrische Isolierung, vorzugsweise eine elektrisch isolierende Ummantelung, sowie mindestens ein Leiterende auf. Das Leiterende des Leiters ist zumindest teilweise abisoliert. Eine Übergangsstelle von isoliertem Leiter zum teilweise abisolierten Leiterende ist in der Leiterführung innerhalb des Dichtkörpers angeordnet. Teilweise abisoliert bedeutet, dass die elektrische Isolierung in einem Bereich des Leiters vollständig entfernt ist. Es ist ebenfalls vorstellbar, dass das Leiterende vollständig abisoliert ist. Unter dem vorgefertigten Dichtkörper mit Leiter ist zu verstehen, dass der Dichtkörper als ganzes Bauteil bereits besteht und als solches in beispielsweise einem Gehäuse für Messinstrumente als ganzes Bauteil eingefügt werden kann.

Die Anordnung der Übergangsstelle innerhalb des Dichtkörpers ermöglicht es, dass der Leiter und die Übergangsstelle vom Dichtkörper vollständig umschlossen sind. Dies ermöglicht es, eine direkte Kontaktierung zwischen Leiter und Dichtmaterial herzustellen und damit an der Übergangsstelle eine besonders gute Dichtung zu erzielen.

Gehäuse für Messinstrumente können zweiteilig ausgebildet sein, wobei ein Dichtkörper zwischen zwei Gehäusehälften angeordnet ist. Derartige Gehäuse können eine umlaufende Trennstelle aufweisen, in die der Dichtkörper eingelegt wird. Der Dichtkörper ist folglich entsprechend der Gehäuseform ausgebildet. Der Dichtkörper ist vorzugsweise in sich geschlossen. Der Dichtkörper kann folglich ringförmig ausgestaltet sein. Die Gehäuse können an ihrer Trennstelle unterschiedliche Querschnitte aufweisen, als Beispiel seien runde, ovale oder polygonale Querschnitte genannt, an die die Form des Dichtkörpers angepasst ist.

Zum Erhöhen der Dichtwirkung weist die Leiterführung vorzugsweise eine bzw. wenigstens auf einer Seite eine Leiterverlängerung auf. Bei einer Anordnung des Dichtkörpers an einem Gehäuse mit Innenraum kann die Leiterverlängerung sowohl im Innenraum des Gehäuses als auch ausserhalb des Gehäuses angeordnet sein. Anstatt der Kombination einer inneren und äusseren Leiterverlängerung ist ebenfalls möglich, eine Leiterverlängerung nur auf einer Seite, entweder nur eine Leiterverlängerung im Innenraum oder nur eine nach aussen gerichtete Leiterverlängerung vorzusehen. Die Leiterverlängerung ermöglicht es, die Permeationsstrecke für Wasser im Bereich der Leiterführung zu verlängern. Als Permeationsstrecke ist die Distanz gemeint, die Flüssigkeit und vorliegend Wasser aufgrund physikalischer Effekte, wie beispielsweise Diffusion, oder aufgrund von Kapillareffekten, beispielsweise aufgrund eines Spalts, im Dichtkörper zurücklegen muss, um in das Gehäuse eindringen zu können. Aus einer Leiterverlängerung resultiert eine längere Permeationsstrecke und daraus resultiert eine erhöhte Dichtigkeit im Bereich der Leiterführung.

Der Leiter kann vorzugsweise dauerhaft mit dem Dichtkörper verbunden sein. Besonders bevorzugt ist der Leiter in das Dichtmaterial des Dichtkörpers einvulkanisiert und/oder verklebt. Dauerhaft bedeutet, dass der Leiter im Bereich seines abisolierten Bereiches eine Verbindung mit dem Dichtkörper eingeht, die eine Abdichtung über einen langen Zeitraum (vorteilhaft mehrere Jahre) sicherstellt. Diese Verbindung ist vorzugsweise adhäsiv, eine kohäsive Verbindung ist ebenfalls möglich. Dichtkörper und Leiterführung können einstückig ausgebildet sein. Eine derartige dauerhafte Verbindung hat den Vorteil, dass der Dichtkörper und die Leiter eine stabile Verbindung bilden. Der Einvulkanisationsprozess ist ein bekanntes und nach gängigen Industriestandards durchführbares Verfahren, was die Prozesssicherheit erhöht und die Qualitätskontrolle vereinfacht. Das Verfahren ist zudem günstig und schnell. Durch die dauerhafte Verbindung des Dichtkörper und der Leiter wird der Materialaufwand verringert und die Lebensdauer erhöht. Für die Einvulkanisation kann der Leiter im betreffenden Bereich mit einem Haftvermittler benetzt oder beschichtet werden. Der so vorbereitete Leiter kann dann in eine Giessform eingebracht werden. Nachdem eine Kautschukmischung in die Giessform gegossen wurde, kann dann der eigentliche Vulkanisierungsschritt vollzogen werden.

Da der Leiter während dem Vulkanisieren hohen Temperaturen ausgesetzt ist, kann es vorteilhaft sein, wenn die elektrische Isolierung ein temperaturbeständiges Material mit einer Temperaturbeständigkeit von mindestens 180°C aufweist. Als bevorzugtes temperaturbeständiges Material kann zum Beispiel PTFE verwendet werden. Dies ermöglicht die Herstellung und Fertigung des Dichtkörpers, ohne dass die Isolierung Schaden nimmt. Ein unerwünschtes Schmelzen der Isolierung lässt sich somit verhindern. Es sind selbstverständlich jedoch auch andere Materialien für die Isolierungvorstellbar. Ein solches Material hat den Vorteil, dass es problemlos im Herstellungsprozess des Dichtkörpers in das Dichtmaterial integriert werden kann.

Alternativ kann der Leiter in einen vorzugsweise schon fertig produzierten Dichtkörper eingeklebt sein. Diese Anordnung hat den Vorteil, dass der Leiter - nicht wie beim Einvulkanisieren - nicht hohen Temperaturen ausgesetzt ist, wodurch auch kostengünstigere Leiter mit beispielsweise einer elektrische Isolierung aus PVC verwendet werden könnten. Es wäre sogar auch denkbar, nackte Leiter (d.h. Leiter ohne Isolierung) zu verwenden und den Leiter, nachdem der Leiter mit dem Dichtkörper verbunden wurde, durch Aufbringen beispielsweise eines elektrisch isolierenden Lackes auf den Leiter zu isolieren.

Vorzugsweise weist die Leiterführung mit der aussenseitigen und/oder innenseitigen Leiterverlängerung eine Ausdehnung in Längsrichtung der Leiter auf, welche zumindest 110%, bevorzugt zumindest 150 % und besonders bevorzugt etwa 500 % einer Abmessung des Dichtkörpers in Richtung der Leiterführung ist. Die Leiterverlängerung im Innenraum (bzw. die innenseitige Leiterführung) weist vorteilhaft im Vergleich zur nach aussen gerichteten Leiterverlängerung eine grössere Ausdehnung auf. Besonders vorteilhaft ist die innenseitige Leiterverlängerung wenigstens doppelt so lang wie die ausseneeitige Leiterverlängerung. Typischerweise weisen derartige Dichtkörper zwei Dichtseiten auf, welche mit abzudichtenden Flächen eines Gehäuses in Wirkverbindung bringbar sind, wobei diese zwei Dichtseiten zwischen sich einen ersten Abstand und eine dazwischenliegende Mittelebene definieren. Die Leiterführung verläuft im Wesentlichen entlang oder parallel zu dieser Mittelebene. Die Dichtseiten sind derart miteinander verbunden, dass sie eine im Querschnitt geschlossene Kontur aufweisen, welche von der Mittelebene an zwei Durchdringungspunkten durchdrungen wird. Der Abstand der Durchdringungspunkte entspricht der vorgenannten Abmessung des Dichtkörpers. Die Leiter sind dadurch über einen grösseren und längeren Bereich dauerhaft mit dem Dichtkörper verbunden. Dies erhöht die Permeationsstrecke und begünstigt die Beständigkeit gegen eindringendes Wasser oder andere Medien.

Die Ausdehnung der Leiterführung entlang des Leiters kann vorzugsweise mehrere Millimeter betragen. Mit einer Leiterführung, die beispielsweise wenigstens 2 mm lang ist, können bereits gute Ergebnisse hinsichtlich Dichtheit erzielt werden.

Vorzugsweise ist die Übergangsstelle im Dichtkörper derart angeordnet, dass der Leiter mindestens auf 20 %, bevorzugt 25 bis 50 % und besonders bevorzugt etwa 75 % einer Länge der Leiterführung abisoliert ist. Dies hat den Vorteil, dass im Bereich der Abisolierung der Leiter eine direkte Verbindung mit dem Dichtkörper eingehen kann.

Vorzugsweise umfasst der Dichtkörper einen Werkstoff mit einem Wasserdampfdiffusionswiderstand grösser als 10'0000. Vorzugsweise ist der Werkstoff ein kautschukbasierter Werkstoff wie EPDM, EPM oder Butylkautschuk oder ein Verschnitt dieser Materialien . Der Wasserdampfdiffusionswiderstand drückt aus, wie stark ein Stoff die Ausbreitung oder Diffusion von Wasserdampf verhindert. Ein hoher Wert des Wasserdampfdiffusionswiderstandes, üblicherweise über 10'0000, kennzeichnet ein besonders dichtes Material und eine besonders lange Permeationsstrecke für Wasser. Kautschukbasierende Werkstoffe zeichnen sich durch eine lange Lebensdauer, Verschleissfestigkeit und gute Vulkanisationsfähigkeit aus. Sie sind zudem witterungsbeständig. Durch die Verwendung eines solchen Materials wird ein Dichtkörper mit hoher Lebensdauer, der bei unterschiedlichen Witterungsverhältnissen, wie beispielsweise Regen, Eis und starker Sonneneinstrahlung einsetzbar ist, geschaffen.

Vorzugsweise weist der Dichtkörper eine Innenseite auf, wobei an der Innenseite im Bereich und vorzugsweise entlang der Leiterführung vorstehende Anschlagsflächen angeordnet sind. Derartige Anschlagsflächen können beispielsweise als Öse oder als Vorsprung ausgeführt sein. Dies ermöglicht es, im Bereich der Leiterführung eine Zugentlastung für die Leiter zu schaffen, womit die Leiter und/oder der Dichtkörper gegen ein Ausreissen gesichert sind. Die Anschlagsflächen können einstückig mit dem Dichtkörper ausgebildet sein. Dies hat den Vorteil, dass keine separaten Vorrichtungen nötig sind. Der Dichtkörper kann in einem Arbeitsschritt hergestellt werden.

Vorzugsweise weist der Dichtkörper eine Ober- und eine Unterseite auf, welche bevorzugt eine Strukturierung, insbesondere eine Anordnung aus Wülsten, aufweisen. Eine Rippung ist ebenfalls vorstellbar. Dabei kann diese Strukturierung wahlweise nur an der Oberseite respektive Unterseite angebracht sein oder sich an beiden Seiten befinden. Als Wülste werden zusätzliche Verdickungen des Dichtematerials bezeichnet, welche vorzugsweise entlang der Dichtung umlaufend ausgebildet sind. Die Wülste können dabei beispielsweise einen halbkreisförmigen, sinusförmigen oder dreieckigen Querschnitt aufweisen. Die Strukturierungen haben den Vorteil, dass die lokale Pressung und damit die Dichtigkeit bei einer Verwendung in einem zweckmässigen Gehäuse erhöht werden.

Ein weiterer Aspekt der Erfindung bezieht sich auf ein Verfahren zur Herstellung eines, wie vorliegend beschriebenen, Dichtkörpers, umfassend die Schritte:
- Bereitstellen einer Dichtkörperform,
- Entfernung der elektrischen Isolierung von zumindest einem Teil des Leiterendes,
- Einlegen des zumindest einen Leiters in die Form, so dass dieser durch die Form durchläuft und das abisolierte Leiterende in einer Übergangsstelle positioniert wird, und
- Befüllen der Form.
Der Leiter wird während der vorstehenden Verfahrensschritte oder in einem zusätzlichen Verfahrensschritt dauerhaft mit dem Dichtkörper verbunden. Die Verbindung zwischen Leiter und Dichtkörper kann bevorzugt eine adhäsive Verbindung sein. Eine kohäsive Verbindung wäre ebenfalls möglich.

Der Dichtkörper kann einstückig hergestellt werden. Die einstückige Herstellung des Dichtkörpers hat den Vorteil, dass sie kostengünstig ist, der Materialaufwand geringer ist und die Verfahrensschritte reduziert werden.

In einer bevorzugten Ausführung des Verfahrens werden die Leiter zur Verbindung mit dem Dichtkörper einvulkanisiert. Das hat den Vorteil, dass eine direkte und sehr stabile Verbindung zwischen Leiter, insbesondere dem abisolierten Leiter, und Dichtkörper hergestellt werden kann und damit eine hohe Dichtigkeit erzeugt wird.

Vorzugsweise wird das abisolierte Leiterende vor dem Einlegen in die Form mit einem Haftvermittler behandelt. Vorzugsweise wird ein Zweikomponenten-Haftvermittler, beispielsweise ChemLok®, Chemosil® oder Parlock™, hergestellt von der Firma Lord Corporation, verwendet. Haftvermittler sind Substanzen, die dazu eingesetzt werden, die Haftfestigkeit zwischen verschiedenen Werkstoffen zu verbessern. Sie besitzen meist unterschiedliche funktionelle Gruppen, die mit den unterschiedlichen Werkstoffoberflächen chemisch reagieren können und dadurch einer Verbindung zweier unterschiedlicher Werkstoffe eine sehr gute Festigkeit und Beständigkeit vermitteln. ChemLok®, Chemasil® und Parlock™ sind besonders für Verbindungen von Metallen und kautschukbasierten Materialien geeignet. Das Behandeln mit dem Haftvermittler hat den Vorteil, dass eine hohe Haftfestigkeit zwischen Leiter und Dichtkörper erzielt wird sowie Beständigkeit gegen Korrosion, höhere Temperaturen, Öle und Lösemittel zwischen Leiterende und Dichtkörper erreicht wird.

Ein weiterer Aspekt der Erfindung betrifft ein Gehäuse für Messinstrumente, insbesondere für Wasserzähler, umfassend einen, vorzugsweise wie vorliegend beschriebenen, vorgefertigten Dichtkörper, der zwischen einem Gehäuseboden und einem Verschlusskörper abdichtend anordbar ist. Der Dichtkörper weist eine Leiterführung zur Durchführung eines Leiters auf, wobei der Leiter eine elektrische Isolierung und vorzugsweise eine elektrisch isolierende Ummantelung und mindestens ein Leiterende aufweist. Das Leiterende ist zumindest teilweise abisoliert und eine Übergangsstelle von isoliertem Leiter zu abisoliertem Leiterende ist in der Leiterführung angeordnet. Eine solche Anordnung ermöglicht beispielsweise einen besonders sicheren Anschluss eines Messinstruments, vorzugsweise eines Wasserzählers, wobei Energie- und/oder Signalübertragung ohne Einbusse auf Dichtigkeit möglich ist. Zudem ist die Montage des Gehäuses einfach.

Vorzugsweise ist der Dichtkörper mit einer Oberseite und/oder einer Unterseite in Wirkverbindung mit einer Oberfläche des Verschlusskörpers und/oder einer Oberfläche des Gehäuses zur Herstellung einer Abdichtung. Eine formschlüssige Verbindung ist vorstellbar. Dadurch wird eine grossflächige Berührung zwischen den einzelnen Bestandteilen ermöglicht, die sich besonders günstig auf Beständigkeit des Gehäuses gegen eindringende Flüssigkeiten wie Wasser auswirkt.

Es ist von Vorteil, wenn die Leiterführung eine Leiterverlängerung aufweist. Bei einer Anordnung des Dichtkörpers an einem Gehäuse kann die Verlängerung sowohl in einem Innenraum des Gehäuses als auch ausserhalb des Gehäuses angeordnet sein. Eine Kombination ist ebenfalls möglich. Die Leiterverlängerung ermöglicht es, die Permeationsstrecke für Wasser an der Position der Leiterführung zu verlängern. Eine längere Permeationsstrecke begünstigt eine höhere Dichtigkeit.

Vorzugsweise besteht zwischen Leiter und Dichtkörper eine dauerhafte Verbindung. In einer bevorzugten Ausführungsform ist der Leiter in das Dichtmaterial des Dichtkörpers einvulkanisiert. Der Leiter geht wenigstens abschnittsweise im Bereich seines abisolierten Bereiches eine Verbindung mit dem Dichtkörper ein. Diese Verbindung vorzugswiese adhäsiv ausgestaltet, eine kohäsive Verbindung ist ebenfalls möglich. Dichtkörper und Leiterführung können einstückig ausgebildet sein. Eine derartige dauerhafte Verbindung hat den Vorteil, dass der Dichtkörper und die Leiter eine stabile Einheit bilden. Der Einvulkanisationsprozess ist ein bekanntes und nach gängigen Industriestandards durchführbares Verfahren, was die Prozesssicherheit erhöht und die Qualitätskontrolle vereinfacht. Das Verfahren ist zudem günstig und schnell. Bekannte Verfahren erleichtern einerseits die Zulassungs- und Zertifizierungsverfahren. Andererseits ist es möglich, mit diesem Verfahren ein Gehäuse bereitzustellen, welches die Bedingungen wenigstens für IP 68 nach DIN-EN 60529 erfüllt. Versuche haben überaschenderweise gezeigt, dass das Gehäusedichtheit sehr hohen Anforderungen genügt.

In einer bevorzugten Ausführung des Gehäuses ist in oder an der abdichtenden Anordnung eine Strukturierung vorgesehen. Die Strukturierung kann eine Anordnung aus Wülsten oder Rippen aufweisen. Als Wülste oder Rippen werden zusätzliche Verdickungen des Dichtkörpers bezeichnet, welche vorzugsweise entlang des Dichtkörpers umlaufend angeordnet sind. Die Wülste können dabei beispielsweise einen halbkreisförmigen, sinusförmigen oder dreieckigen Querschnitt aufweisen. Die Strukturierung kann am Gehäuseboden und/oder am Verschlusskörper und/oder an einer Oberseite und/oder Unterseite des Dichtkörpers angeordnet sein. Die Strukturierung kann entlang dem Dichtkörper oder entlang dem Gehäuse umlaufend sein. Komplementäre Flächen an allen drei Bauteilen sind ebenfalls möglich. Solche Strukturierungen erhöhen die lokale Pressung und damit die Dichtigkeit. Ebenfalls wird die Oberfläche vergrössert, was wiederum eine längere Permeationsstrecke für das Wasser ergibt.

Vorzugsweise umfasst das Gehäuse eine Messeinrichtung für ein Messinstrument, insbesondere für einen Wasserzähler. Ein Gaszähler oder Stromzähler ist ebenfalls möglich.

Ein weiterer Aspekt der Erfindung betrifft ein Messinstrument, insbesondere einen Wasserzähler, mit einem wie vorliegend beschriebenem Gehäuse und/oder wie vorliegend beschriebenen Dichtkörper. Solche Messinstrumente sind von äusseren Umwelteinflüssen geschützt und können daher eine hohe Lebensdauer aufweisen.

Anhand von Figuren, welche lediglich Ausführungsbeispiele darstellen, wird die Erfindung im Folgenden näher erläutert. Es zeigen:
- Figur 1: ein erfindungsgemässes Gehäuse für Messinstrumente in einer perspektivischen Darstellung,
- Figur 2: das Gehäuse aus Figur 1 in einer Schnittansicht,
- Figur 3: einen Dichtkörper für das Gehäuse aus Figur 1 in einer perspektivischen Darstellung, und
- Figur 4: ein Detail aus der Schnittansicht der Figur 2.

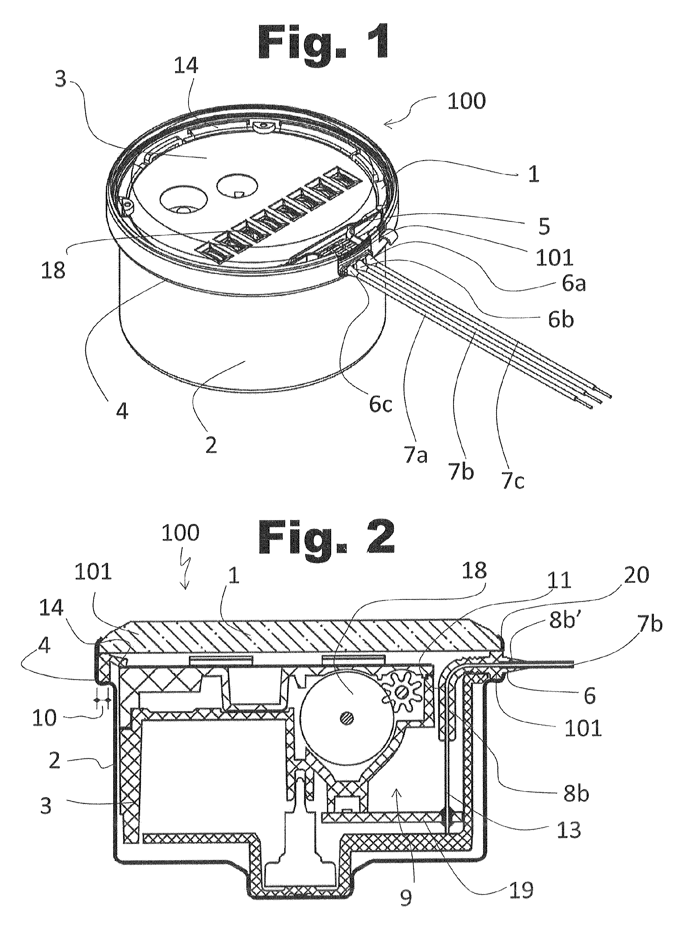

Figur 1 zeigt ein Messinstrument mit einem erfndungsgemässen Gehäuse 100 in einer perspektivischen Darstellung. Das Gehäuse 100 umfasst einen Dichtkörper 101, einen Verschlusskörper 1 und einen Gehäuseboden 2 mit integrierter Messeinrichtung 3 für das Messinstrument. Vorliegend ist das Messinstrument beispielhaft ein Wasserzähler. Wasserzähler sind Volumenmessgeräte für Wasser zur Messung der von der Wasserversorgung gelieferten Wassermenge. Die gemessene Menge wird mittels eines mechanischen Rollenzählwerkes dargestellt und ist visuell ablesbar. Der in Figur 1 dargestellte Wasserzähler verfügt über ein mechanisches Rollenzählwerk mit acht Zahlenrädern. Derartige Wasserzähler sind seit längerer Zeit bekannt und gebräuchlich. Wasserzähler sind zum Beispiel aus der EP 502 306 A2 bekannt geworden. Moderne Wasserzähler verfügen über eine elektronische Bestimmung des Zählwerkstandes des mechanischen Rollenzählwerkes, wodurch eine Fernauslesung möglich ist. Hierzu ist der Wasserzähler verkabelt, die jeweiligen Kabel oder Leiter sind mit 7a, 7b, 7c bezeichnet. Aus der EP 660 264 B1 kann entnommen werden, wie der Zählerstand ausgelesen werden könnte. Der vorliegende Wasserzähler zeichnet sich durch eine besonders gute und effiziente Abdichtung aus, die sehr hohen Anforderungen genügt. Das nachfolgend im Detail beschriebene Gehäuse 100 könnte allerdings auch für andere Einsatzgebiete verwendet werden.

Der Dichtkörper 101 ist in einer Aussparung oder Aufnahme 4 des Gehäusebodens 2 angeordnet. Der Dichtkörper 101 kann in die durch eine an der Oberseite des Gehäusebodens angeordnete umlaufende Rinne gebildete Aufnahme 4 eingesetzt werden (vgl. nachfolgende Fig. 2). Der plattenartige Verschlusskörper 1 kann danach auf Dichtkörper abgelegt werden, worauf durch Bördeln des oberen Randes des Gehäusebodens 2 der Verschlusskörper 1 im Gehäuse fixiert wird. Der becherförmige Gehäuseboden 2 ist vorliegend beispielhaft aus Kupfer gefertigt. Der Gehäuseboden könnte aber auch aus Aluminium oder Stahl bestehen; aber auch Kunststoffmaterialien sind möglich. Der Verschlusskörper 1 ist zum Beispiel aus Glas oder aus einem transparenten Kunststoff gefertigt. Anschläge 5 am Gehäuseboden 2, welche mit Anschlägen am Dichtkörper 101 (hier nicht gezeigt) zusammenwirken, verhindern ein unbeabsichtigtes Herausziehen oder Hineindrücken des Dichtkörpers 101 aus oder in das Gehäuse 100. Der Dichtkörper 101 weist drei Leiterführungen 6a, 6b, 6c zur Durchführung jeweils eines Leiters 7a, 7b, 7c auf.

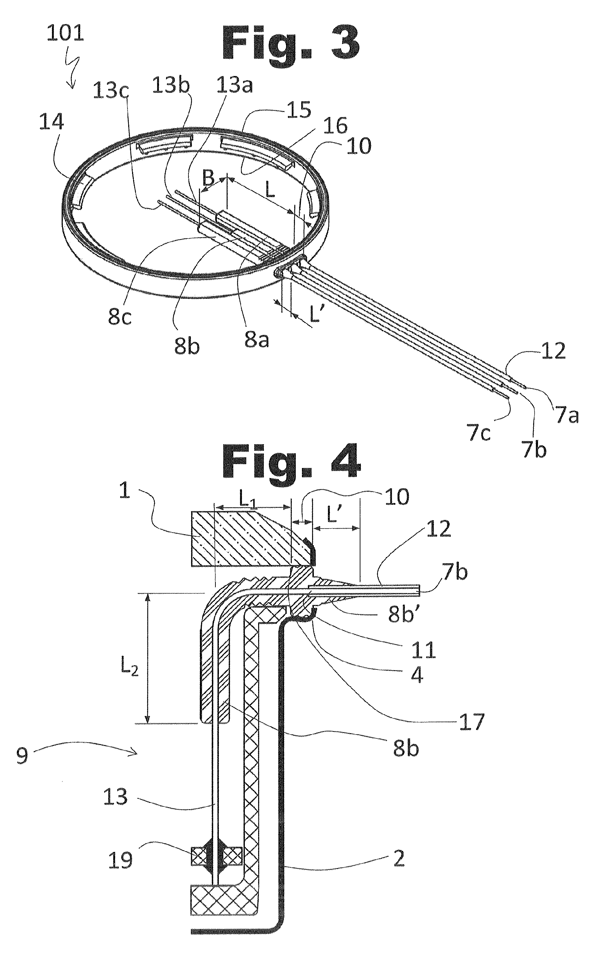

Figur 2 zeigt das Gehäuse 100 aus Figur 1 in einer Schnittansicht quer durch das Gehäuse 100 entlang einer Ebene durch den Leiter 7b. Der Dichtkörper 101 weist dabei eine Leiterverlängerung 8b in den Innenraum 9 des Gehäuses 100 auf. Die Länge L der Leiterverlängerung 8b in den Innenraum 9 entspricht dem ca. 10-fachen der Abmessung 10 des Dichtkörpers 101. Der Dichtkörper 101 weist auch eine LeiterVerlängerung 8b' nach aussen auf, deren Länge L' dem ca. 4-fachen der Abmessung 10 des Dichtkörpers 101 entspricht. Eine Übergangsstelle 11 zwischen einem Leiter 7b mit Isolierung 12 und abisolierten Leiterende 13 ist im Dichtkörper 101 angeordnet. Der Leiter 7b ist bis ans Ende der Leiterverlängerung 8b abisoliert. Es kann jedoch auch nur ein Teil des Leiters 7b innerhalb der Leiterverlängerung 8b abisoliert sein. Der Dichtkörper 101 ist in einer Aussparung 4 des Gehäusebodens 2 angeordnet. Angeformte Bereiche als Niederhalter 14 am Dichtkörper 101 fixieren die Messeinrichtung 3. Die hier als Wasserzähler ausgestaltete Messeinrichtung 3 weist Zahlenrädern 18 auf. Die Niederhalter werden in Figur 3 genauer beschrieben. Die an den ringförmigen Abschnitt des Dichtkörpers auf beiden Seiten anschliessenden Leiterverlängerung sind einstückig mit diesem Dichtungsring verbunden und bilden einen monolithischen Dichtkörper. Der Gehäuseboden 2 ist mit dem Verschlusskörper 1 verschlossen. Aus Figur 2 ist weiterhin der mit 20 bezeichnete Bördelrand am oberen Rand des Gehäusebodens 2 erkennbar, der sich auf den Verschlusskörper abstützt und diesen festhält. Die im Innenraum des Gehäuses befindliche Messeinrichtung weist eine Platine 19 auf. Für die elektrische Verbindung ist das abisolierte Leiterende 13 des Leiters 7b an die Platine 19 gelötet. Die elektrische Verbindung mit der Platine könnte selbstverständlich auch auf andere Weise erfolgen.

Figur 3 zeigt eine Ausführung des erfindungsgemässen ringförmigen Dichtkörpers 101 in einer perspektivischen Darstellung. Für quadratische oder dreieckige Gehäuse ist der Dichtkörper entsprechend umgestaltet. Der Dichtkörper 101 besteht aus EPDM: Der Dichtkörper kann aber auch andere kautschukbasierende Werkstoffe wie EPM oder Butylkautschuk umfassen, ein Verschnitt dieser Materialien (z.B. EPM Peroxid) ist ebenfalls möglich. Die Leiterführungen 6a, 6b, 6c zur Durchführung der Leiter 7a, 7b, 7c verlaufen durch den Dichtkörper (101) und weisen eine Leiterverlängerung 8a, 8b, 8c auf. An den ringförmigen Abschnitt mit der Abmessung 10 schliessen beidseits Leiterverlängerungen 8, 8' an. Die Länge L (vgl. nachfolgende Fig. 4: Länge L ist hier L1 + L2) der Leiterverlängerung 8a und 8c entspricht in der Länge dem 10-fachen der Abmessung 10 des Dichtkörpers 101 und in der Breite B dem 2-fachen der Abmessung 10 des Dichtkörpers 101. Die Leiterverlängerung 8b ist in der Länge gegenüber 8a und 8c etwas verkürzt, kann aber auch gleichlang ausgebildet sein. Die Leiterverlängerungen 8a, 8b, 8c weisen in das Innere des Dichtkörpers 101. Die Leiter 7a, 7b, 7c weisen eine Isolierung 12 auf, die Leiterenden 13a, 13b, 13c der Leiter 7a, 7b, 7c sind abisoliert. Der Dichtkörper 101 ist zusätzlich mit Niederhaltern 14 gefertigt. Die Niederhalter 14 sind beispielsweise bei einem Giessprozess zur Herstellung des Dichtkörpres einstückig am Dichtkörper 101 angeformt. Die Niederhalter 14 zeigen in Richtung eines Zentrums des Dichtkörpers 101. Sie haben eine im Querschnitt viereckige Form, andere polygonale Formen sind ebenfalls vorstellbar. Sie weisen unterschiedliche Ausdehnungen auf. Sie halten, wie aus Figur 2 ersichtlich, das Messinstrument im Gehäuse. Der Dichtkörper 101 weist eine Oberseite 15 und eine Unterseite 16 auf. Der Dichtkörper 101 weist an der Oberseite 15 umlaufende Wülste 17 auf.

Figur 4 zeigt ein Detail der Schnittansicht des Dichtkörpers 101 aus Figur 2 entlang des Leiters 7b mit einem Bereich der Leiterverlängerung 8b. Der Dichtkörper 101 ist dauerhaft mit dem Leiter 7b verbunden. Der Leiter 7b ist in das Dichtmaterial des Dichtkörpers 101 einvulkanisiert. Dadurch entsteht eine Baueinheit aus Dichtkörper 101 und Leitern 7a, 7b, 7c. Die Leiter sind im Dichtkörper 101 integriert und fest mit diesem verbunden. Diese Baueinheit (siehe auch Fig. 2) lässt sich einfach als Ganzes in den Gehäuseboden einsetzen. Somit ist sichergestellt, dass sich das Gehäuse einfach und in wenigen Schritten zusammenbauen lässt. Eine Übergangsstelle 11 zwischen dem Leiter 7b mit Isolierung 12 und abisoliertem Leiterende 13 ist innerhalb des Dichtkörpers 101 angeordnet. Der Dichtkörper 101 ist in einer Aussparung 4 des Gehäusebodens 2 angeordnet. An der Oberseite 15 und Unterseite 16 weist der Dichtkörper 101 Strukturierungen 17, insbesondere eine Anordnung aus Wülsten auf. Diese Wülste sind in der gezeigten Ausführung im Querschnitt sinusförmig ausgebildet. Eine im Querschnitt halbkreisförmige oder dreieckige Strukturierung ist ebenfalls möglich. Die Wülste schmiegen sich an den Verschlusskörper an. In der Grafik überschneiden sich Verschlusskörper 1 und Dichtkörper 101 bzw. die Wülste 17 des Dichtkörpers 101. Hierbei handelt es sich um eine vereinfachte Darstellung der realen Verhältnisse.

## Patentansprüche

1. Dichtkörper (101), mit einer Leiterführung (6a, 6b, 6c) zur Durchführung eines Leiters (7a, 7b, 7c), wobei der Dichtkörper (101) vorgefertigt ist und wobei der Leiter (7a, 7b, 7c) eine elektrische Isolierung (12), vorzugsweise eine elektrisch isolierende Ummantelung, und mindestens ein Leiterende (13) aufweist, **dadurch gekennzeichnet, dass** das Leiterende (13) zumindest teilweise abisoliert ist und eine Übergangsstelle (11) von isoliertem Leiter (7a, 7b, 7c) zum teilweise abisolierten Leiterende (13) in der Leiterführung (6a, 6b, 6c) innerhalb des Dichtkörpers (101) angeordnet ist.

2. Dichtkörper (101) gemäss Anspruch 1, wobei die Leiterführung (6a, 6b, 6c) eine Leiterverlängerung (8a, 8b, 8c) aufweist.

3. Dichtkörper (101) gemäss Anspruch 2, wobei die Leiterführung (6a, 6b, 6c) eine nach innen gerichtete Leiterverlängerung (8a, 8b, 8c) und/oder eine nach aussen gerichtete Leiterverlängerung (8a', 8b', 8c') aufweist, wobei die innenseitige Leiterverlängerung (8a, 8b, 8c) in Bezug auf die Richtung der Leiterführung eine grössere Ausdehnung als die aussenseitige Leiterverlängerung (8a', 8b', 8c') aufweist.

4. Dichtkörper (101) gemäss einem der Ansprüche 1 bis 3, wobei der Leiter (7a, 7b, 7c) mit dem Dichtkörper (101) verbunden ist und/oder wobei der Leiter (7a, 7b, 7c) bevorzugt in das Dichtmaterial des Dichtkörpers (101) einvulkanisiert ist.

5. Dichtkörper (101) gemäss einem der Ansprüche 1 bis 4, wobei die elektrische Isolierung (12) ein temperaturbeständiges Material mit einer Temperaturbeständigkeit von mindestens 180°C, bevorzugt PTFE, umfasst.

6. Dichtkörper (101) gemäss einem der Ansprüche 2 bis 5, wobei die Leiterführung (6a, 6b, 6c) mit der Leiterverlängerung (8a, 8b, 8c) eine Ausdehnung in Längsrichtung aufweist, welche zumindest 110 % und bevorzugt 150 % einer Abmessung (10) des Dichtkörpers (101) in Richtung der Leiterführung (6a, 6b, 6c) ist.

7. Dichtkörper (101) gemäss einem der Ansprüche 2 bis 6, wobei Leiterverlängerung (8a, 8b, 8c) eine Abmessung (10) in Richtung der Leiterführung (6a, 6b, 6c) von wenigstens 1 mm und bevorzugt wenigstens 2 mm aufweist.

8. Dichtkörper (101) gemäss einem der Ansprüche 1 bis 7, wobei die Übergangsstelle (11) derart angeordnet ist, dass der Leiter (7a, 7b, 7c) mindestens auf 20 %, bevorzugt 25 bis 50 % und besonders bevorzugt 75 %, einer Länge (L) der Leiterführung (6a, 6b, 6c) abisoliert ist.

9. Dichtkörper (101) gemäss einem der Ansprüche 1 bis 8, wobei der Dichtkörper (101) einen Werkstoff mit einem Wasserdampfdiffusionswiderstand grösser als 10'000, vorzugsweise ein kautschukbasierter Werkstoff wie EPDM, EPM oder Butylkautschuk oder ein Verschnitt dieser Materialien, umfasst.

10. Dichtkörper (101) gemäss einem der Ansprüche 1 bis 9, wobei an einer Innenseite des Dichtkörpers (101) im Bereich und vorzugsweise entlang der Leiterführung (6a, 6b, 6c) vorstehende Anschlagsflächen zur Zugentlastung angeordnet sind.

11. Dichtkörper (101) gemäss einem der Ansprüche 1 bis 10, wobei der Dichtkörper (101) eine Oberseite (15) und eine Unterseite (16) aufweist, welche bevorzugt eine Strukturierung (17) und insbesondere eine Anordnung aus Wülsten aufweisen.

12. Verfahren zur Herstellung eines Dichtkörpers (101), gemäss einem der Ansprüche 1 bis 11, umfassend die Schritte:
- Bereitstellen einer Dichtkörperform,
- Entfernung der elektrischen Isolierung (12) von zumindest einem Teil des Leiterendes (13),
- Einlegen des zumindest einen Leiters (7a, 7b, 7c) in die Form, so dass dieser durch die Form durchläuft und das abisolierte Leiterende (13) in einer Übergangsstelle (11) positioniert wird,
- Befüllen der Form,
**dadurch gekennzeichnet, dass** der Leiter (7a, 7b, 7c) in einem vorstehenden oder zusätzlichen Verfahrensschritt dauerhaft mit dem Dichtkörper (101) verbunden wird.

13. Gehäuse (100) für Messinstrumente (3), insbesondere für Wasserzähler, umfassend einen vorgefertigten Dichtkörper (101), insbesondere nach einem der Ansprüche 1 bis 14, und einen Verschlusskörper (1), wobei der vorgefertigte Dichtkörper (101) zwischen einem Gehäuseboden (2) und dem Verschlusskörper (1) abdichtend anordbar oder angeordnet ist, und mit einer Leiterführung (6a, 6b, 6c) zur Durchführung eines Leiters (7a, 7b, 7c), wobei der Leiter (7a, 7b, 7c) eine elektrische Isolierung (12) und mindestens ein Leiterende (13) aufweist, **dadurch gekennzeichnet, dass** das Leiterende (13) zumindest teilweise abisoliert ist und eine Übergangsstelle (11) von isoliertem Leiter (7a, 7b, 7c) zu abisoliertem Leiterende (13) in der Leiterführung (6a, 6b, 6c) angeordnet ist.

14. Messinstrument (3), insbesondere Wasserzähler, mit einem Gehäuse (100) nach Anspruch 12 und/oder einem Dichtkörper nach einem der Ansprüche 1 bis 11.
